# EUROPÄISCHE PATENTSCHRIFT

(11) **EP 0 977 998 B1**
(45) Veröffentlichungstag und Bekanntmachung des Hinweises auf die Patenterteilung: **12.09.2001**
(21) Anmeldenummer: 98931932.2
(22) Anmeldetag: 16.04.1998
(51) Int. Cl.: G01R 13/30

(54) **DATENVERARBEITUNGSANLAGE UND VERFAHREN ZUR VISUALISIERUNG EINES GRADIENTEN IN EINEM AUF EINEM BILDSCHIRM DARGESTELLTEN DIAGRAMM**
DATA PROCESSING SYSTEM AND METHOD FOR VISUALLY DISPLAYING A GRADIENT IN A DIAGRAM REPRESENTED ON A SCREEN
SYSTEME DE TRAITEMENT DE DONNEES ET PROCEDE POUR VISUALISER UN GRADIENT DANS UN DIAGRAMME REPRESENTE SUR UN ECRAN

(30) Priorität: 23.04.1997 DE 19717137
(43) Veröffentlichungstag der Anmeldung: 09.02.2000
(73) Patentinhaber: SIEMENS AKTIENGESELLSCHAFT, 80333 München (DE)
(72) Erfinder: MÜLLER, Paul, D-91056 Erlangen (DE); PFADLER, Heinrich, D-91058 Erlangen (DE); RÜCKER-LÜSSOW, Jürgen, D-90579 Langenzenn (DE)
(86) Internationale Anmeldenummer: DE9801072
(87) Internationale Veröffentlichungsnummer: WO9848286

(56) Entgegenhaltungen:
- EP-A- 0 283 996
- DE-A- 2 146 312
- DE-A- 2 938 847
- FR-A- 2 644 609
- US-A- 3 445 765
- US-A- 4 852 055
- US-A- 5 004 975

## Beschreibung

Datenverarbeitungsanlage und Verfahren zur Visualisierung eines Gradienten in einem auf einem Bildschirm dargestellten Diagramm.

Die Erfindung betrifft eine elektronische Datenverarbeitungsanlage mit einem Bildschirm und bildschirmgesteuerten Mitteln zur Darstellung eines Diagramms, insbesondere bei der Steuerung eines industriellen Prozesses.

Es sind Informationssysteme bekannt geworden, die gemessene, analoge Größen, welche bei physikalischen Prozessen auftreten, auf einem Bildschirm visuell darstellen können. Solche Informationssysteme werden in elektronischen Datenverarbeitungsanlagen implementiert und beispielsweise in Leitständen zur Visualisierung von Betriebszuständen industrieller Anlagen, z.B. von Kraftwerken, eingesetzt.

In der Regel werden Istwerte, Sollwerte, Kennlinien oder andere Prozeßdaten zu Prozeßsignalen verarbeitet, die als Diagramme, Zeitkurvenanzeigen oder andere Graphen dargestellt werden. Durch Menüsteuerung und Steuermittel, die z.B. einen Cursor oder eine elektronische "Maus" umfassen können und bei Heimcomputern bekannt sind, kann in den Prögrammablauf der Datenverarbeitungsanlage und die Auswahl und Darstellung der Prozeßdaten eingegriffen werden. Darüber hinaus ist es bei Peilgeräten üblich, statt der herkömmlichen mechanischen Peilhilfsmittel oder Lesehilfsmittel (Glas- oder Plexiglaslineal) ein elektronisches Peillineal zu verwenden. Hierzu wird beispielsweise auf die Dokumente DE 29 38 847 A1, US 5,004,975 und US 3,445,765 verweisen. Dabei ist das in den Dokumenten jeweils offenbarte Hilfsmittel lediglich zum Ablesen von einzelnen Werten auf der zugehörigen Skala. Besonders nachteilig ist, daß insbesondere das Differential oder die Änderungsgeschwindigkeit der zugrundeliegenden Größe nicht ausgelesen werden kann.

Für die Bewertung des Prozeßablaufs oder die Prognose bei Eingriffen in die Prozeßsteuerung ist häufig die Änderungsgeschwindigkeit bestimmter Prozeßdaten bzw. der Gradient der entsprechenden dargestellten Prozeßsignale eine wichtige Information, die schnell und einfach zu erhalten sein sollte. Sie kann in solchen Steuer- oder Informationssystemen über Rechenfunktionen ermittelt werden, die aufwendige Interpolationen, Glättungsalgorithmen oder anderen Rechenaufwand erfordern, und deren Genauigkeit auch davon abhängt, daß ein aussagekräftiger Abschnitt des entsprechenden Graphen ausgewählt wird, also keine Abschnitte, die zu kurz, zu lang oder zu sehr von Störungen überlagert sind. Die rechnerisch ermittelten Werte für die Änderungsgeschwindigkeiten konnen häufig zu unbefriedigenden Ergebnissen führen. So kann es, abhängig vom angewandten mathematischen Verfahren, zu unerwünschten zeitlichen Verzogerungen bis zur richtigen Wertermittlung kommen oder die Genauigkeit der ermittelten Werte ist zu gering, was z.B. bei der Abbildung von instabilen Betriebszuständen auftreten kann.

Die Erfindung hat sich die Aufgabe gestellt, ein Verfahren anzugeben, mit dem in einer solchen Datenverarbeitungsanlage eine Anderungsgeschwindigkeit eines auf einem Bildschirm dargestellten Verlaufs eines Prozeßsignales rasch ermittelt und gegebenenfalls dargestellt werden kann.

Die Aufgabe wird erfindungsgemäß dadurch gelöst, daß in das graphische Bild, das auf dem Bildschirm den Verlauf eines oder mehrerer Prozeßsignale als Diagramm graphisch darstellt, ein Gradientenlineal eingeblendet wird. Als Gradientenlineal wird dabei die Darstellung einer zwischen zwei Punkten verlaufenden geraden Linie verstanden, die auf dem Bildschirm so verschoben werden kann, wie ein Lineal als Zeichenwerkzeug auf einem Zeichenblatt. Dieses Gradientenlineal wird vom Bedienpersonal an dem dargestellten Verlauf positioniert. Anhand der Steigung des Gradientenlineals wird dann das Differential oder die Änderungsgeschwindigkeit einer, dem Prozeßsignal zugrundeliegenden, physikalischen Größe ermittelt.

Das Gradientenlineal kann innerhalb des Diagramms parallel an einen Punkt des Diagramms verschoben werden, an dem die Änderungsgeschwindigkeit näherungsweise ermittelt werden soll; z.B. kann ein Endpunkt oder ein beliebiger Punkt auf dem Gradientenlineal auf einen gewünschten Punkt des Diagramms gelegt werden. Das Bedienpersonal kann dann den Verlauf des Diagramms mit dem Gradientenlineal visuell vergleichen.

Es kann die Änderungsgeschwindigkeit auch ermittelt werden, indem im Diagramm zwei prägnante Vergangenheitspunkte mit Hilfe des Gradientenlineals verbunden werden und daraus die gesuchte Größe errechnet wird.

Nach der Erfindung kann die Steigung des Gradientenlineals auch durch eine optische Interpolation der Steigung des Diagramms ermittelt werden.

Es ist erfindungsgemäß auch möglich, daß das Gradientenlineal mit einer vorbestimmten Sollsteigung an einem beliebigen Punkt des Diagramms dargestellt wird. Durch Vergleich mit dem Diagramm kann dann z.B. beurteilt werden, ob der Prozeß ordnungsgemäß ablauft.

Der Wert der Steigung des Gradientenlineals wird vorteilhaft zusammen mit seiner Einheit als Näherung für die Änderungsgeschwindigkeit angezeigt. Die Anzeige kann auf dem Bildschirm z.B. außerhalb des Diagramms des Prozeßverlaufes erfolgen.

Dabei ist insbesondere vorteilhaft, daß durch ein in der Datenverarbeitungsanlage installiertes Programm jeder Steigung des eingeblendeten Lineals automatisch der Zahlenwert dieser Steigung (einschließlich der gewünschten physikalischen Einheiten) zugeordnet werden kann. Umgekehrt kann in jedem Punkt auf dem Bildschirm durch Angabe des Gradienten ein einzublendendes Gradientenlineal vorgegeben werden.

Das Gradientenlineal kann mit fortschreitendem Prozeßverlauf parallel an die Position des aktuellsten Prozeßsignals verschoben werden oder aber fest an einer einmal gewählten Position verharren. Es kann z.B. vorgesehen sein, daß das Gradientenlineal automatisch an den aktuellsten Wert positioniert wird, wenn es mittels eines Cursors an einen Punkt der Zukunft, also über das Diagramm hinaus, verschoben wird. Wird die Steigung visuell an das dargestellte Diagramm angepaßt, so kann der künftige Prozeßverlauf prognostiziert werden. Es kann durch Vorgabe einer Sollsteigung festgelegt werden, wie die physikalischen Größen eines Prozesses gesteuert werden sollen.

Werden mehrere relevante Prozeßsignale auf dem Bildschirm gleichzeitig in entsprechenden Diagrammen dargestellt, so kann ein Gradientenlineal einem Diagramm bzw. einem Prozeßsignal zugeordnet werden; es können aber auch mehrere Gradientenlineale einem und/oder mehreren Prozeßsignalen zugeordnet werden. Dabei kann z.B. für ein Gradientenlineal und die Anzeige seiner Steigung eine andere Farbe verwendet werden als für andere Gradientenlineale.

Entsprechend sieht die Erfindung eine elektronische Datenverarbeitungsanlage vor, die einen Bildschirm zur Darstellung eines Diagramms und bildschirmgesteuerte Mittel zum Einblenden und/oder Verschieben des Gradientenlineals im dargestellten Diagramm besitzt.

Nachfolgend wird die Erfindung und insbesondere die elektronische Datenverarbeitungsanlage anhand mehrerer Figuren näher erläutert. Es zeigen:
- FIG 1: Ein Bildschirm-Bild mit dem Diagramm von Prozeßverläufen mehrerer Prozeßsignale mit zugeordneten Gradientenlinealen;
- FIG 2: Ein Bild mit dem Diagramm eines fortschreitenden Funktionsverlaufes eines Prozeßsignales mit zugeordnetem Gradientenlineal;
- FIG 3: Ein Bild mit dem Diagramm eines fortschreitenden Prozeßverlaufes mit zugeordnetem Gradientenlineal;
- FIG 4: Die elektronische Datenverarbeitungsanlage mit dem Bildschirm.

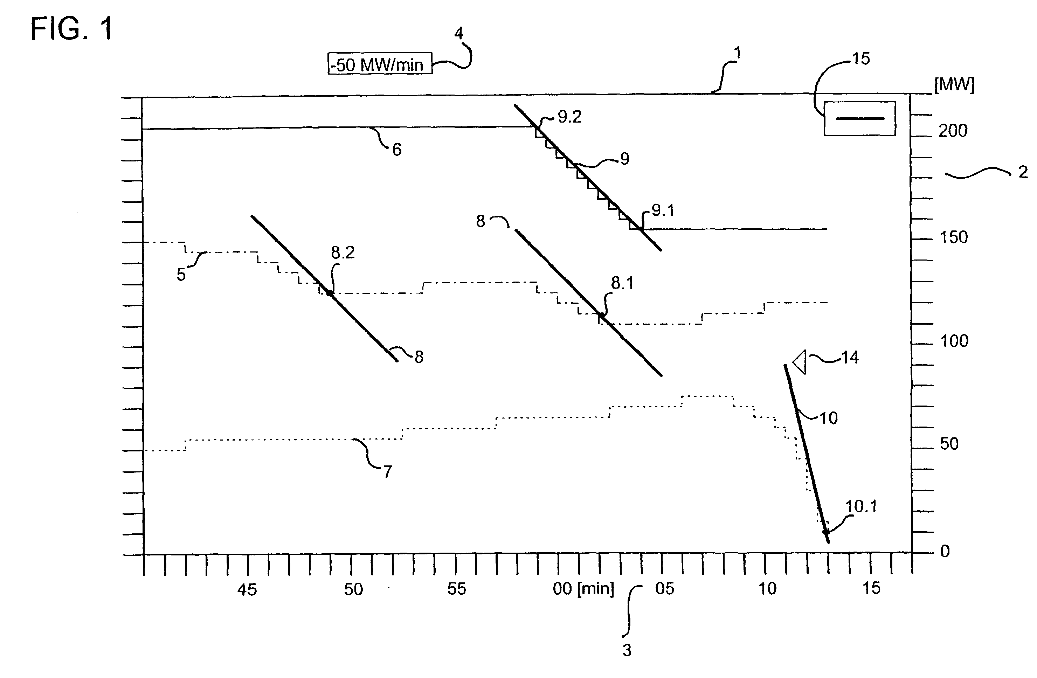

Fig. 1 zeigt ein graphisches Bild 1 mit zugeordneten Achsen 2,3, in welchem die Verläufe von mehreren Prozeßsignalen 5,6,7 eines Prozesses gleichzeitig graphisch dargestellt sind. Im Beispiel handelt es sich bei Fig. 1 um die Leistung verschiedener Aggregate eines Kraftwerks.

Das Bedienpersonal kann ein Gradientenlineal mit Hilfe eines als Steuermittel ausgefuhrten Symbols 15, welches auf dem Bildschirm dargestellt werden kann, aktivieren. Das Gradientenlineal kann nach der Aktivierung eine beliebige Steigung aufweisen. Es ist ebenfalls vorgesehen, daß die Steigung des Gradientenlineals eingebbar und damit frei wählbar ist.

Das Gradientenlineal kann dann vom Bedienpersonal parallel am Bildschirm zu einem beliebigen Punkt verschoben werden. Durch Aktivieren eines Punktes, z.B. Punkt 8.2, auf dem zugehörigen Diagramm eines Prozeßverlaufes, kann das Gradientenlineal 8 am Diagramm 5 positioniert werden. Die Steigung des Gradientenlineals kann beispielsweise durch Eingabe eines Sollwertes in einer numerischen Anzeige 4 der Steigung des Gradientenlineals verändert werden.

Das Bedienpersonal kann ein Gradientenlineal auch positionieren, indem zwei Punkte, z.B. 9.1, 9.2 auf einem Diagramm aktiviert werden, und das Gradientenlineal, z.B. 9, auf diesen Punkten 9.1, 9.2 zu liegen kommt, so daß die Punkte 9.1 und 9.2 Schnittpunkte von Diagramm 6 und Gradientenlineal 9 darstellen. Die Änderungsgeschwindigkeit des Prozesses und seines zugehörigen Diagramms 6 wird näherungsweise mit dem Gradientenlineal 9 bestimmt, welches zwei pragnante Vergangenheitspunkte 9.1, 9.2 miteinander verbindet. Die Steigung des Gradientenlineals 9 entspricht in diesem Fall der mittleren Steigung des Prozeßverlaufes zwischen den beiden Vergangenheitspunkten 9.1, 9.2.

Das Bedienpersonal kann ein Gradientenlineal auch durch Aktivieren eines Punktes 10.1 auf einem Diagramm 7 an diesen Punkt verschieben und um diesen Punkt mit Hilfe eines Cursors 14, der als Steuermittel ausgeführt ist, drehen, um die Steigung des Gradientenlineals 10 dort optisch an die Steigung des Diagramms 7 anzupassen. Im Diagramm 7 wird so die momentane Änderungsgeschwindigkeit des zugehörigen Prozeßverlaufs mit dem Gradientenlineal 10 mit optischer Interpolation näherungsweise ermittelt.

Im Diagramm 5 wird eine vorgegebene Sollsteigung des Gradientenlineals 8 an zwei unterschiedlichen Stellen 8.1, 8.2 des Diagramms 5 dargestellt. Im graphischen Bild auf dem Bildschirm der Datenverarbeitungsanlage können vom Bedienpersonal gleichzeitig mehrere Gradientenlineale 8, 9, 10 eingeblendet werden. Zusätzlich können weitere Diagramme, auch ohne zugeordnete Gradientenlineale, eingeblendet werden.

Die Steigung mit der zugehörigen Einheit eines ausgewählten Gradientenlineals kann in einem Feld 4, z.B. außerhalb des graphischen Bildes 1, mit zugeordneten Achsen 2,3, dargestellt werden. Ebenso können die Steigungen mehrerer oder sämtlicher Gradientenlineale mit ihren Einheiten dargestellt werden. Dabei kann durch Verwendung unterschiedlicher Farben eine Unterscheidung zwischen den verschiedenen Gradientenlinealen vorgenommen werden.

Die Formate der angezeigten Steigungen der Gradientenlineale konnen durch das interne Rechenprogramm der Datenverarbeitungsanlage automatisch den zugehörigen Diagrammen und den ihnen zugeordneten Größen und physikalischen Einheiten angepaßt werden.

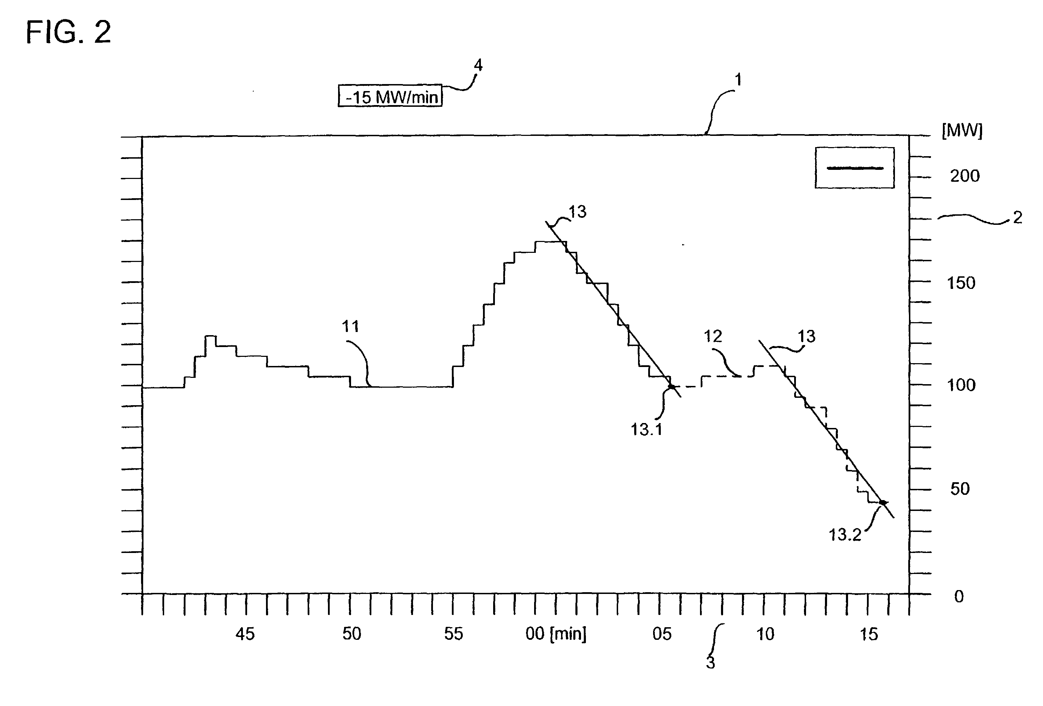

Fig. 2 zeigt ein graphisches Bild 1 mit zugeordneten Achsen 2,3 in dem ein Diagramm 11 eines Prozesses dargestellt ist.

Das Gradientenlineal 13 zeigt die angenäherte Änderungsgeschwindigkeit des Prozeßverlaufes 11 im Punkt 13.1. Mit fortschreitendem Prozeßverlauf 12 wird das Gradientenlineal 13 an die Position des aktuellsten Prozeßsignals 13.2 des Diagramms parallel verschoben.

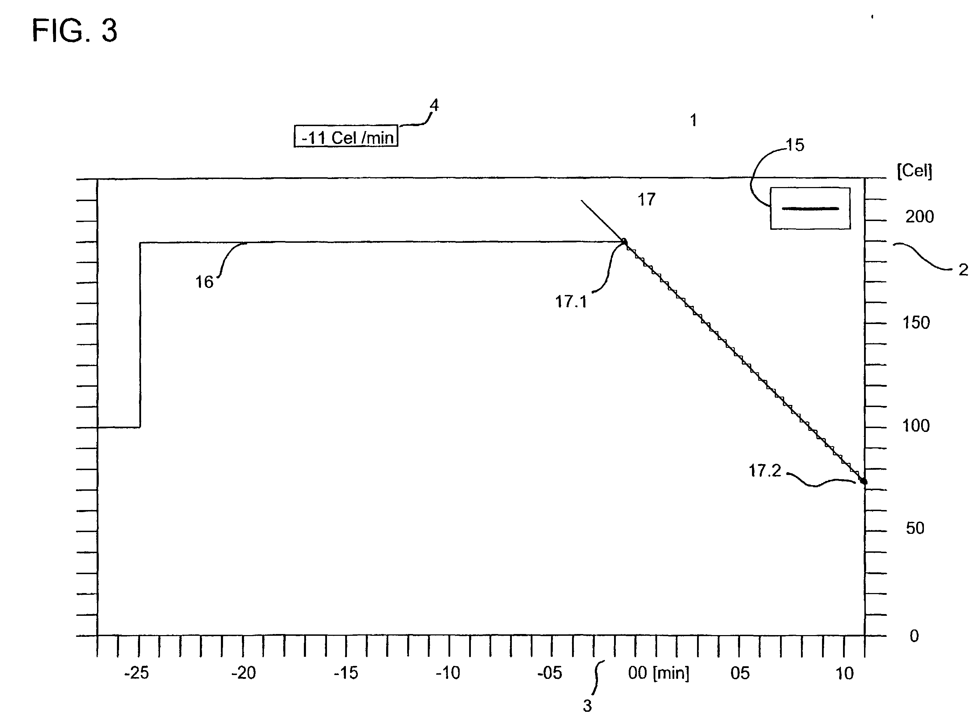

Fig. 3 zeigt ein graphisches Bild 1 mit zugeordneten Achsen 2,3 in dem ein Diagramm 16 des Temperaturverlaufs eines Prozesses dargestellt ist. In diesem Beispiel soll das Steuerprogramm für eine geplante Abschaltung des Kraftwerks festgelegt werden, wobei die Leistung stufenweise erniedrigt und im Mittel eine optimale Abkühlungsgeschwindigkeit eingehalten werden soll. Der Punkt 17.1 markiert die Position des aktuellsten Prozeßsignales. Diese Position besitzt den Wert 00 auf der Zeitachse 3. Die Prozeßsignale der Vergangenheit aus dem Diagramm 16 liegen im Bereich der negativen Werte auf der Achse 3. Zukünftige Prozeßsignale liegen im Bereich der positiven Werte der Achse 3.

Das Bedienpersonal aktiviert das Gradientenlineal mit Hilfe des graphischen Symbols 15 und verschiebt dieses z.B. durch Aktivieren des Punktes 17.1 an die Position des aktuellsten Prozeßsignales. Die Steigung des Gradientenlineales 17 kann dann durch Aktivieren eines zweiten Punktes 17.2 festgelegt werden. Das Personal kann dann die geplante Temperaturabsenkung ohne Umrechnung direkt in den richtigen physikalischen Einheiten im Feld 4 ablesen und mit dem optimalen Wert vergleichen. Es ist aber auch moglich, die Steigung des Gradientenlineales durch Angabe einer Sollsteigung, z.B. im Feld 4, festzulegen. Das Gradientenlineal 17 repräsentiert nun den zukünftigen Sollverlauf des Prozesses.

Im weiteren Verlauf des Prozesses wird bei dieser Programmvariante das Gradientenlineal mit der vorgegebenen Sollsteigung stets durch den aktuellsten Punkt des tatsächlichen Temperaturverlaufes gelegt, so daß das Bedienpersonal abschätzen kann, ob die tatsächliche Temperaturabsenkung bisher dem vorgegebenen Sollwert der Abkühlungsgeschwindigkeit entsprochen hat und voraussichtlich plangemäß ablaufen wird.

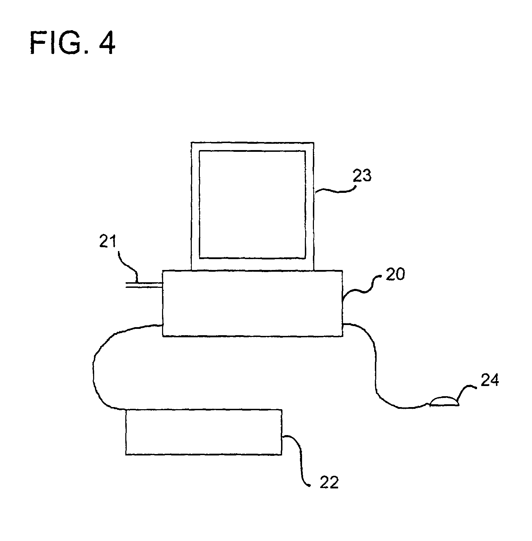

Gemäß Fig. 4 erhalt die Datenverarbeitung, z.B. ein zentraler Rechner 20 in der Leitstelle eines Kraftwerks, über eine Busleitung 21 Prozeßdaten von dezentralen Meß- und Kontrolleinrichtungen, die von dem zentralen Rechner koordiniert werden. Über eine Tastatur 22 kann das Personal Datenlisten aus dem abgelaufenen oder laufenden Prozeß abrufen, die auf dem Bildschirm 23 numerisch und/oder in Form von Diagrammen abgebildet werden, und Befehle und/oder Daten einspeisen, um den laufenden Prozeß zu steuern, geänderte Abläufe des Prozesses zu simulieren oder kunftige Prozeßabläufe zu projektieren. Die Visualisierung der Daten, Prozeßsignale und Diagramme geschieht bildschirmgesteuert, d.h. auf dem Bildschirm wird in Form von einem Menü, Bildschirmsymbolen oder anderen Zeichen ausgegeben, welche Programme im Rechner hierfür installiert sind und durch entsprechende Befehle über die Tastatur 22 und/ oder eine elektronische "Maus" 24, die insbesondere einen Cursor auf dem Bildschirm bewegen kann, aktiviert werden können. Ist die Darstellung eines bestimmten Diagramms aktiviert, so erscheint gleichzeitig mit dem Diagramm auch das Symbol 15 des Gradientenlineals und das Feld 4 für dessen Steigung. Wenn das entsprechende, durch das Symbol 15 repräsentierte Programm aktiviert wird, dann wird das Gradientenlineal selbst auf dem Bildschirm dargestellt, wobei die Lage des Gradientenlineals beliebig sein kann und anschließend an einen markierten Punkt auf dem Bildschirm verschoben wird oder auch vorher durch Markieren eines Punktes bereits vorgegeben sein kann. Ebenso kann die Steigung des dargestellten Gradientenlineals zunächst beliebig sein und nachher durch Überschreiben des Feldes 4 oder Markieren eines zweiten Punktes verändert werden oder von vornherein durch eine entsprechende Eingabe vorgegeben werden.

Mit der Darstellung des Gradientenlineals auf dem Bildschirm einer gemäß der Erfindung programmierten Datenverarbeitungsanlage, erhält das Personal also ein Hilfsmittel, das die Analyse oder Diagnose tatsächlich abgelaufener oder simulierter Prozesse und/oder Projektierung künftiger Prozesse wesentlich erleichtert.

## Patentansprüche

1. Elektronische Datenverarbeitungsanlage mit einem Bildschirm zur Darstellung eines den Verlauf eines Prozeßsignals umfassenden Diagramms (6, 7, 8) und Steuermitteln (14,15), um ein Gradientenlineal (8,9,10) in das dargestellte Diagramm (6,7,8) einzublenden und auf dem Bildschirm zu verschieben, wobei die Steigung des eingeblendeten Gradientenlineals (8, 9, 10) zur Ermittlung des Differentials oder der Änderungsgeschwindigkeit einer dem Prozeßsignal zugrundeliegenden physikalischen Größe dient.

2. Datenverarbeitungsanlage nach Anspruch 1,
**dadurch gekennzeichnet, daß** das Gradientenlineal (10) durch Aktivieren eines Punktes (10.1) auf dem Diagramm (7) an dem Diagramm (7) positionierbar ist.

3. Datenverarbeitungsanlage nach Anspruch 2,
**dadurch gekennzeichnet, daß** das Gradientenlineal (9) durch Aktivieren von zwei Diagrammpunkten (9.1,9.2) derart am Diagramm (6) positionierbar ist, daß die beiden Diagrammpunkte (9.1,9.2) auf dem Gradientenlineal (9) liegen.

4. Datenverarbeitungsanlage nach Anspruch 1 oder 2,
**dadurch gekennzeichnet, daß** das Gradientenlineal (8) auf dem Bildschirm parallel verschiebbar ist.

5. Datenverarbeitungsanlage nach Anspruch 1 oder 2,
**dadurch gekennzeichnet, daß** die Steigung des einzublendenden Gradientenlineals (10) eingebbar ist.

6. Datenverarbeitungsanlage nach einem der Ansprüche 1 bis 5,
**dadurch gekennzeichnet, daß** die Steigung des eingeblendeten Gradientenlineals (10). veränderlich ist.

7. Datenverarbeitungsanlage nach Anspruch 1 oder 2,
**dadurch gekennzeichnet, daß** das Gradientenlineal (17) automatisch an einem Endpunkt (17.1) des Diagramms (16) positionierbar ist, wobei die Steigung des Gradientenlineals einer Fortsetzung des Diagramms entspricht.

8. Datenverarbeitungsanlage nach Anspruch 7 in Kombination mit Anspruch 5 oder 6,
**dadurch gekennzeichnet, daß** die Steigung des Gradientenlineals (7) als Sollwert für die Fortsetzung des Diagramms eingebbar ist.

9. Datenverarbeitungsanlage nach einem der Ansprüche 5 bis 8,
**dadurch gekennzeichnet, daß** die Steigung des Gradientenlineals als numerischer Sollwert eingebbar ist.

10. Datenverarbeitungsanlage nach einem der Ansprüche 1 bis 9,
**dadurch gekennzeichnet, daß** die Steigung des eingeblendeten Gradientenlineals (17) numerisch auf dem Bildschirm anzeigbar ist (4).

11. Datenverarbeitungsanlage nach Anspruch 10,
**dadurch gekennzeichnet, daß** die numerische Anzeige (4) der Steigung mit einem Sollwert überschreibbar, und die Steigung des eingeblendeten Gradientenlineals dem Sollwert anpaßbar ist.

12. Datenverarbeitungsanlage nach Anspruch 10,
**dadurch gekennzeichnet, daß** die Anzeige (4) der Steigung automatisch dem Format des Diagramms und den physikalischen Einheiten der im Diagramm dargestellten Größen anpaßbar ist.

13. Datenverarbeitungsanlage nach einem der Ansprüche 1 bis 12,
**dadurch gekennzeichnet, daß** mehrere Gradientenlineale (7,8,9) gleichzeitig einblendbar sind.

14. Datenverarbeitungsanlage nach einem der Ansprüche 1 bis 13,
**dadurch gekennzeichnet, daß** auch weitere Diagramme (5,6,7) einblendbar sind.

15. Leitstelle einer Anlage zur Durchführung eines industriellen Prozesses mit einer Datenverarbeitungsanlage nach einem der Ansprüche 1 bis 14 zur graphischen Darstellung mindestens eines Prozeßsignals auf dem Bildschirm.

16. Visualisierung eines Gradientenlineals in einem den Verlauf eines Prozeßsignales darstellenden und auf einem Bildschirm in einem graphischen Bild wiedergegebenen Diagramm, wobei ein Gradientenlineal eingeblendet und am Diagramm derart positioniert wird, daß anhand der Steigung des Gradientenlineales ein Differential oder eine Änderungsgeschwindigkeit einer dem Prozeßsignal zugrundeliegenden physikalischen Größe ermittelt wird.

17. Verfahren nach Anspruch 16,
**dadurch gekennzeichnet, daß** die Änderungsgeschwindigkeit des Prozeßsignals durch eine Steigung des Gradientenlineals angenähert wird, indem mit dem Gradientenlineal zwei prägnante Vergangenheitspunkte des Diagramms miteinander verbunden werden oder die Steigung des Diagramms in einem Punkt optisch angenähert wird.

18. Verfahren nach Anspruch 16 oder 17,
**dadurch gekennzeichnet, daß** das Gradientenlineal mit einer vorbestimmten Sollsteigung an einem Punkt des Diagramms dargestellt wird.

19. Verfahren nach Anspruch 16 bis 18,
**dadurch gekennzeichnet**, daß das Gradientenlineal einem vorgebbaren Format des Diagramms und/oder dem Format der physikalischen Größe automatisch angepaßt wird.

20. Verfahren nach einem der Ansprüche 16 bis 19,
**dadurch gekennzeichnet**, daß mehrere Gradientenlineale einem und/oder mehreren im graphischen Bild dargestellten Prozeßverläufen zugeordnet werden.

21. Verfahren nach einem der Ansprüche 16 bis 20,
**dadurch gekennzeichnet**, daß der Wert der Änderungsgeschwindigkeit von einem oder mehreren Gradientenlinealen mit den zugehörigen Einheiten ausgegeben wird.

## Claims

1. Electronic data-processing system having a screen for representing a diagram (5, 6, 7), which includes the characteristic of a process signal, and control means (14, 15) for superimposing a gradient rule (8, 9, 10) on the diagram (5, 6, 7) which is represented and moving it on the screen, the gradient of the superimposed gradient rule (8, 9, 10) being used to ascertain the differential or the rate of change of a physical variable which forms the basis of the process signal.

2. Data-processing system according to claim 1, **characterised in that** the gradient rule (10) can be positioned on the diagram (7) by activating a point (10.1) on the diagram (7).

3. Data-processing system according to claim 2, **characterised in that** the gradient rule (9) can be positioned on the diagram (6) by activating two points (9.1, 9.2) on the diagram, in such a way that the two points (9.1, 9.2) on the diagram lie on the gradient rule (9).

4. Data-processing system according to claim 1 or 2, **characterised in that** the gradient rule (8) can be moved in a parallel manner on the screen.

5. Data-processing system according to claim 1 or 2, **characterised in that** the gradient of the gradient rule (10) to be superimposed can be input.

6. Data-processing system according to one of claims 1 to 5, **characterised in that** the gradient of the superimposed gradient rule (10) is variable.

7. Data-processing system according to claim 1 or 2, **characterised in that** the gradient rule (17) can automatically be positioned at an end point (17.1) of the diagram (16), the gradient of the gradient rule corresponding to a continuation of the diagram.

8. Data-processing system according to claim 7 in combination with claim 5 or 6, **characterised in that** the gradient of the gradient rule (10) can be input as a desired value for the continuation of the diagram.

9. Data-processing system according to one of claims 5 to 8, **characterised in that** the gradient of the gradient rule can be input as a numerical desired value.

10. Data-processing system according to one of claims 1 to 9, **characterised in that** the gradient of the superimposed gradient rule (17) can be displayed numerically (4) on the screen.

11. Data-processing system according to claim 10, **characterised in that** the numerical display (4) of the gradient can be overwritten with a desired value, and the gradient of the superimposed gradient rule can be adapted to the desired value.

12. Data-processing system according to claim 10, **characterised in that** the display (4) of the gradient can be matched automatically to the format of the diagram and the physical units of the variables represented in the diagram.

13. Data-processing system according to one of claims 1 to 12, **characterised in that** a plurality of gradient rules (8, 9, 10) can be superimposed simultaneously.

14. Data-processing system according to one of claims 1 to 13, **characterised in that** further diagrams (5, 6, 7) can also be superimposed.

15. Control centre of an installation for carrying out an industrial process, having a data-processing system according to one of claims 1 to 14 for the graphic representation of at least one process signal on the screen.

16. Visual display of a gradient rule in a diagram which represents the characteristic of a process signal and is reproduced on a screen in a graphic image, wherein a gradient rule is superimposed and positioned on the diagram in such a way that, with the aid of the gradient of the gradient rule, a differential or a rate of change of a physical variable which forms the basis of the process signal is ascertained.

17. Method according to claim 16, **characterised in that** the rate of change of the process signal is approximated by a gradient of the gradient rule, by connecting to each other with the gradient rule two concise points in the past on the diagram, or the gradient of the diagram is approximated optically at one point.

18. Method according to claim 16 or 17, **characterised in that** the gradient rule is represented with a predetermined desired gradient at a point on the diagram.

19. Method according to claim 16 to 18, **characterised in that** the gradient rule is automatically matched to a predeterminable format of the diagram and/or to the format of the physical variable.

20. Method according to one of claims 16 to 19, **characterised in that** a plurality of gradient rules are assigned to one process characteristic and/or to a plurality of process characteristics represented in the graphic image.

21. Method according to one of claims 16 to 20, **characterised in that** the value of the rate of change of one or more gradient rules is output with the associated units.

## Revendications

1. Système de traitement de données électronique ayant un écran pour représenter un diagramme (5, 6, 7) comprenant la courbe d'un signal de processus et des moyens de commande (14, 15) pour insérer une règle à gradient (8, 9, 10) dans le diagramme représenté (5, 6, 7) et pour la déplacer sur l'écran, la pente de la règle à gradient insérée (8, 9, 10) servant à déterminer la dérivée ou la variation de vitesse d'une grandeur physique à la base du signal de processus.

2. Système de traitement de données selon la revendication 1,
**caractérisé par** le fait que la règle à gradient (10) peut être positionnée sur le diagramme (7) en activant un point (10.1) sur le diagramme (7).

3. Système de traitement de données selon la revendication 2,
**caractérisé par** le fait que la règle à gradient (9) peut être positionnée sur le diagramme (6) en activant deux points de diagramme (9.1, 9.2) de telle sorte que les deux points de diagramme (9.1, 9.2) se trouvent sur la règle à gradient (9).

4. Système de traitement de données selon la revendication 1 ou 2,
**caractérisé par** le fait que la règle à gradient (8) peut être déplacée parallèlement sur l'écran.

5. Système de traitement de données selon la revendication 1 ou 2,
**caractérisé par** le fait que la pente de la règle à gradient à insérer (10) peut être entrée.

6. Système de traitement de données selon l'une des revendications 1 à 5,
**caractérisé par** le fait que la pente de la règle à gradient insérée (10) est variable.

7. Système de traitement de données selon la revendication 1 ou 2,
**caractérisé par** le fait que la règle à gradient (17) peut être positionnée automatiquement à une extrémité (17.1) du diagramme (16), la pente de la règle à gradient correspondant alors à une progression du diagramme.

8. Système de traitement de données selon la revendication 7 en combinaison avec la revendication 5 ou 6,
**caractérisé par** le fait que la pente de la règle à gradient (10) peut être entrée comme valeur de consigne pour la progression du diagramme.

9. Système de traitement de données selon l'une des revendications 5 à 8,
**caractérisé par** le fait que la pente de la règle à gradient peut être entrée en tant que valeur de consigne numérique.

10. Système de traitement de données selon l'une des revendications 1 à 9,
**caractérisé par** le fait que la pente de la règle à gradient insérée (17) peut être affichée (4) sous forme numérique sur l'écran.

11. Système de traitement de données selon la revendication 10,
**caractérisé par** le fait que l'affichage numérique (4) de la pente peut être recouvert par l'écriture d'une valeur de consigne et que la pente de la règle à gradient insérée peut être adaptée à la valeur de consigne.

12. Système de traitement de données selon la revendication 10,
**caractérisé par** le fait que l'affichage (4) de la pente peut être adapté automatiquement au format du diagramme et aux unités physiques des grandeurs représentées dans le diagramme.

13. Système de traitement de données selon l'une des revendications 1 à 12,
**caractérisé par** le fait que plusieurs règles à gradients (8, 9, 10) peuvent être insérées simultanément.

14. Système de traitement de données selon l'une des revendications 1 à 13,
**caractérisé par** le fait que d'autres diagrammes (5, 6, 7) peuvent aussi être insérés.

15. Poste de commande d'une installation pour la mise en oeuvre d'un processus industriel ayant un système de traitement de données selon l'une des revendications 1 à 14 pour la représentation graphique d'un signal de processus sur l'écran.

16. Visualisation d'une règle à gradient dans un diagramme qui représente la courbe d'un signal de processus et qui est reproduit sur un écran dans une image graphique, une règle à gradient étant insérée et positionnée dans le diagramme de telle sorte que, à l'aide de la pente de la règle à gradient, on peut déterminer une dérivée ou une vitesse de variation d'une grandeur physique à la base du signal de processus.

17. Procédé selon la revendication 16,
**caractérisé par** le fait qu'on approche la vitesse de variation du signal de processus par une pente de la règle à gradient en reliant avec la règle à gradient deux points antérieurs significatifs du diagramme ou en approchant de façon optique la pente du diagramme en un point.

18. Procédé selon la revendication 16 ou 17,
**caractérisé par** le fait qu'on représente la règle à gradient avec une pente de consigne prédéterminée en un point du diagramme.

19. Procédé selon l'une des revendications 16 à 18,
**caractérisé par** le fait qu'on adapte automatiquement la règle à gradient à un format pouvant être prescrit du diagramme et/ou au format de la grandeur physique.

20. Procédé selon l'une des revendications 16 à 19,
**caractérisé par** le fait qu'on associe plusieurs règles à gradients à une et/ou plusieurs courbes de processus représentées dans l'image graphique.

21. Procédé selon l'une des revendications 16 à 20,
**caractérisé par** le fait qu'on donne en sortie la valeur de la vitesse de variation d'une ou plusieurs règles à gradients avec les unités associées.
